# EUROPÄISCHE PATENTANMELDUNG

(11) **EP 1 990 846 A2**
(43) Veröffentlichungstag der Anmeldung: **12.11.2008**
(21) Anmeldenummer: 08008499.9
(22) Anmeldetag: 06.05.2008
(51) Int. Cl.: H01L 51/52

(54) **Photovoltaisches Modul mit organischen Schichten auf Polymerbasis**

(30) Priorität: 07.05.2007 DE 102007021843
(71) Anmelder: Leonhard Kurz Stiftung & Co. KG, 90763 Fürth (DE)
(72) Erfinder: Schindler, Ulrich, Dr., 90762 Fürth/Bayern (DE); Heilmann, Michael, 91301 Forchheim (DE)
(74) Vertreter: LOUIS, PÖHLAU, LOHRENTZ

(57) **Zusammenfassung**

Es wird ein als Mehrschichtkörper ausgebildetes photovoltaisches Modul (2) mit auf einer Trägerschicht (20) angeordneten photovoltaischen Zellen (21, 211) mit mindestens einer zwischen einer ersten und einer zweiten Elektrodenschicht (212, 215) angeordneten organischen photoaktiven Schicht (213) auf Polymerbasis beschrieben, die in einer Serienschaltung elektrisch miteinander verbunden sind. Lochblocker-Schichten (214) und die Elektronenblocker-Schichten (212) in der Serienschaltung aufeinander folgender benachbarter photovoltaischer Zellen (21, 21 i) sind in Bezug auf die Trägerschicht (20) zueinander in inverser Abfolge angeordnet. Durch einen elektrisch leitenden Verbindungsabschnitt (22) elektrisch miteinander verbundene Elektrodenschichten (211, 215) der aufeinander folgenden benachbarten photovoltaischen Zellen (21, 21 i) sind in einer gemeinsamen Ebene angeordnet.

## Beschreibung

Die Erfindung betrifft ein aus photovoltaischen Zellen mit organischer Polymer-Halbleiterschicht bzw. Halbleiterschichten gebildetes photovoltaisches Modul.

Photovoltaische Zellen mit photoaktiven organischen Schichten auf Polymerbasis haben bislang Wirkungsgrade, die sich im Bereich von 3 bis 5 % bewegen. Das sind Wirkungsgrade, die deutlich niedriger sind als die von anorganischen Solarzellen.

Werden zur Herstellung von flexiblen Solarzellen auf Polymerbasis kostengünstige Fertigungsverfahren, wie beispielsweise das Rolle-zu-Rolle-Verfahren eingesetzt, so ist eine Massenproduktion von Solarzellen in erheblichem Umfang denkbar. Um zu praktisch anwendbaren Lösungen zu gelangen, müssen dabei jeweils mehrere photovoltaische Zellen zu Modulen zusammengeschlossen werden, die für den jeweiligen Anwendungsfall eine angemessene Ausgangsspannung und/oder einen angemessenen Ausgangsstrom bereitstellen.

Der Erfindung liegt nun die Aufgabe zugrunde, ein photovoltaisches Modul auf Polymerbasis zu schaffen, das einfach in der Herstellung ist und einen verbesserten Wirkungsgrad aufweist.

Erfindungsgemäß wird diese Aufgabe mit dem Mehrschichtkörper nach Anspruch 1 und dem Verfahren nach Anspruch 14 gelöst. Es wird ein als Mehrschichtkörper ausgebildetes photovoltaisches Modul vorgeschlagen, mit zwei oder mehr auf einer Trägerschicht angeordneten photovoltaischen Zellen, die in einer Serienschaltung elektrisch miteinander verbunden sind, wobei die photovoltaischen Zellen eine erste und eine zweite Elektrodenschicht und mindestens eine organische photoaktive Schicht auf Polymerbasis aufweisen, die zwischen einer Lochblocker-Schicht und einer Elektronen-Blocker-Schicht angeordnet ist, wobei vorgesehen ist, dass die Lochblocker-Schichten und die Elektronenblocker-Schichten in der Serienschaltung aufeinander folgende benachbarte photovoltaische Zellen in Bezug auf die Trägerschicht zueinander in inverser Abfolge angeordnet sind, und dass die durch einen elektrisch leitenden Verbindungsabschnitt elektrisch miteinander verbundenen Elektrodenschichten der aufeinander folgenden benachbarten photovoltaischen Zellen in einer gemeinsamen Ebene angeordnet sind.

Weiter wird ein Verfahren zur Herstellung eines als Mehrschichtkörper ausgebildeten photovoltaischen Moduls mit zwei oder mehr in Serie geschalteter photovoltaischer Zellen vorgeschlagen, wobei die photovoltaischen Zellen eine erste und eine zweite Elektrodenschicht und mindestens eine organische photoaktive Schicht auf Polymerbasis aufweisen, die zwischen einer Lochblocker-Schicht und einer Elektronenblocker-Schicht angeordnet ist, wobei vorgesehen ist, dass bei dem Verfahren auf eine Trägerschicht die weiteren Schichten so aufgebracht werden, dass die Lochblocker-Schichten und die Elektronenblocker-Schichten in der Serienschaltung aufeinander folgender benachbarter photovoltaischer Zellen in Bezug auf die Trägerschicht zueinander in inverser Abfolge angeordnet sind, und dass die durch einen elektrisch leitenden Verbindungsabschnitt elektrisch miteinander verbundenen Elektrodenschichten der aufeinander folgenden benachbarten photovoltaischen Zellen in einer gemeinsamen Ebene angeordnet sind.

Die photoaktiven Schichten der photovoltaischen Zellen des erfindungsgemäßen photovoltaischen Moduls weisen, wie weiter unten näher beschrieben, halbleitende Polymere auf, im Gegensatz beispielsweise zu Farbstoffzellen bzw. Grätzel-Zellen, die auf der Basis von photoaktiven Farbstoffen aufgebaut sind, so dass es sich um unterschiedliche Wirkprinzipe handelt.

Durch die Ausbildung in der Serienschaltung aufeinander folgender benachbarter photovoltaischer Zellen mit inverser Abfolge nehmen die Zellen eine solche Lage ein, dass zumindest die Außenflächen, d.h. die von der photoaktiven Schicht abgewandten Oberflächen in Serie geschalteter Elektroden in einer Ebene liegen und daher mit einem in dieser gemeinsamen Ebene verlaufenden elektrischen Verbindungsabschnitt verbindbar sind. Es werden also keine senkrecht verlaufenden Verbindungsabschnitte zwischen in der Serienschaltung aufeinander folgenden benachbarten Zellen benötigt, die zum einen die nutzbare Fläche des photovoltaischen Moduls einschränken und die zum anderen einen gegenüber der erfindungsgemäßen Lösung erhöhten Fertigungsaufwand erfordern, weil sie in einer zu den Schichtebenen senkrechten Ebene ausgebildet sind. Unterschiedliche Schichtdicken der Elektrodenschichten stellen also die erfindungsgemäße Lösung nicht in Frage. In der Serienschaltung aufeinanderfolgende photovoltaische Zellen sind vorteilhafterweise als benachbarte Zellen ausgebildet, so dass besonders einfache Zellenanordnungen mit besonders hoher Flächenausnutzung möglich sind.

Das erfindungsgemäße photovoltaische Modul kann in einem Rolle-zu-Rolle-Verfahren kostengünstig hergestellt werden, wobei aufeinander folgende Schichtaufträge vorgesehen sind. Dabei kann jede der Schichten den Anforderungen entsprechend strukturiert sein, wobei die Strukturierung ausdrücklich umfasst, dass bereichsweise in einer Schicht unterschiedliches Material aufgetragen ist, beispielsweise eine Schicht bereichsweise aus dem für die erste Elektrodenschicht vorgesehenen Material, dem für die zweite Elektrodenschicht vorgesehen Material und dem für die Verbindungsabschnitte vorgesehen Material ausgebildet ist. Im Rolle-zu-Rolle-Verfahren können strukturierte Schichten beispielsweise registergenau aufgedruckt werden, ggf. in mehreren Durchgängen. Als Druckverfahren können beispielsweise Tiefdruck, Tintenstrahldruck oder Rakeln vorgesehen sein. Es können aber auch andere Auftragstechnologien, wie Aufschleudern, Sputtern oder Aufdampfen vorgesehen sein.

Sofern eine elektrisch isolierende Trennschicht zwischen benachbarten photovoltaischen Zellen vorgesehen ist, kann diese vor dem Aufbringen der letzten Elektrodenschichten und der Verbindungsabschnitte beispielsweise durch Rakeln aufgebracht werden. Sie füllt dabei die Zwischenräume zwischen den Zellen auf, wobei die Konturen der Trennschicht durch die Randkonturen der Zellen bestimmt sind. Es sind also keine Maßnahmen zum passergenauen Auftrag zu ergreifen.

Weitere vorteilhafte Ausbildungen sind in den Unteransprüchen bezeichnet.

Vorteilhafterweise kann vorgesehen sein, dass die Schichtdicken der photovoltaischen Zellen so gewählt sind, dass benachbarte Schichten aufeinander folgender benachbarter photovoltaischer Zellen jeweils mit gleicher Dicke ausgebildet sind. Hierdurch ergeben sich im produktionstechnischen Verfahren Vorteile, da beispielsweise im Tiefdruck die Rasterwalze gleichmäßig aufliegt und somit ein gleichmäßigerer Ausdruck gewährleistet wird, wogegen die freie Gestaltungsmöglichkeit der photovoltaischen Zelle nur unwesentlich eingeschränkt ist. Zwei Zahlenbeispiele sollen das verdeutlichen:
Bei 5 Schichten sind die 1. und die 5. Schicht sowie die 2. und die 4. Schicht mit gleicher Schichtdicke auszubilden, d.h. es sind bei einer ungeraden Schichtanzahl jeweils die Schichten mit gleicher Schichtdicke auszubilden, die von der mittleren Schicht her die gleiche Position einnehmen. Bei 6 Schichten sind die 1. und die 6. Schicht, die 2. und die 5. Schicht sowie die 3. und die 4. Schicht mit gleicher Schichtdicke auszubilden, d.h. es sind bei einer geraden Schichtanzahl jeweils die zueinander symmetrisch liegenden Schichten mit gleicher Schichtdicke auszubilden. Auf diese Weise sind nebeneinander angeordnete benachbarte Bereiche ausbildbar, die unter Berücksichtigung von Dickentoleranzen in einer Ebene angeordnet sind. Vorteilhafterweise sollen die Dickentoleranzen nicht mehr als 50 % der Solldicke betragen.

Unter Elektrodenschichten, die in einer gemeinsamen Ebene angeordnet sind, ist so eine Anordnung von Elektrodenschichten zu verstehen, bei denen eine gemeinsame Ebene durch die Elektrodenschichten legbar ist. Vorzugsweise liegen hierbei die Oberseite und/oder Unterseite der Elektroden jeweils in einer gemeinsamen Ebene. Es ist jedoch auch möglich, dass insbesondere bei unterschiedlicher Schichtdicke die Elektroden nicht miteinander fluchten, jedoch die oben beschriebene gemeinsame Schnittebene besteht.

Weiter kann vorgesehen sein, dass die Schichten der photovoltaischen Zellen zwischen den Elektroden mit ähnlichen Schichtdicken ausgebildet sind (Schichtdickenvariation < 20%).

Es kann bzw. können neben den für die Funktion der organischen photovoltaischen Zelle primär vorgesehenen Schichten, nämlich Elektrodenschichten, Blocker-Schichten und photoaktive Schicht(en) eine weitere Schicht bzw. weitere Schichten vorgesehen sein, die beispielsweise für eine bessere Effizienz des Moduls oder der Zellen sorgen können. Es kann sich dabei um Schichten handeln, die im Schichtverbund der photovoltaischen Zelle eine feste Lage einnehmen, wie die weiter unten beschriebenen Blocker-Schichten, oder die im Schichtverbund des photovoltaischen Moduls eine feste Lage einnehmen. Ist letzteres vorgesehen, nimmt die Schicht bzw. nehmen die Schichten nicht an der Invertierung teil, d.h. sie bilden jeweils im photovoltaischen Modul eine gemeinsame Ebene. Es kann sich dabei beispielsweise um eine Filterschicht oder um eine Lichtkonzentratorschicht oder dergleichen handeln, die jeweils von der Invertierung ausgenommen sind und in der regulären Zelle und in der inversen Zelle eine unterschiedliche Position in Bezug auf die restlichen Schichten einnehmen.

Die photoaktive Schicht kann beispielsweise aus einem Gemisch aus als Donator wirkendem konjugiertem Polymer, wie P3HT (regioreguläres poly(3-hexyl thiophene) oder MDMO-PPV [poly(2-methoxy-5-(3-,7-dimethyloctyloxy)-1,4-phenylenvinylen], und als Akzeptor wirkenden Fullerenen, wie C₆₀, oder PCBM ([6,6]-phenyl-C₆₁-butric acid methyl ester) aufgebaut sein.

Es sind auch photoaktive Schichten möglich, bei denen sowohl der Akzeptor als auch der Donator aus halbleitenden Polymeren aufgebaut sind und die deshalb besonders kostengünstige Ausführungen erlauben.

Es kann ein Mischungsverhältnis von 2 : 0,5 bis 0,5 : 2 zwischen dem Elektronen-Donator und dem Elektronen-Akzeptor bevorzugt sein.

Weiter kann die photoaktive Schicht auch aus zwei übereinander angeordneten Teilschichten aufgebaut sein, die jedoch als sehr dünne Teilschichten ausgebildet sein müssen, um unerwünschte Rekombinationen der Ladungsträger zu reduzieren und den Widerstand in Richtung der Flächennormalen nicht unnötig zu erhöhen. Werden die Teilschichten sehr dünn ausgebildet, dann kann die Kurzschlussfestigkeit einer aus Teilschichten aufgebauten photoaktiven Schicht geringer sein als der als relativ dicke Schicht von etwa 100 nm Dicke ausgebildeten weiter oben genannten Mischschicht.

Bei der aus zwei übereinander angeordneten Teilschichten ausgebildeten photoaktiven Schicht ist vorzusehen, dass bei zueinander invertierten photovoltaischen Zellen die Orientierung der photoaktiven Schichten invertiert ist, d.h. dass die Schichtfolge der beiden Teilschichten invertiert ist und somit auch alterniert. Es handelt sich also bei der aus zwei Teilschichten ausgebildeten photoaktiven Schicht um eine polarisierte photoaktive Schicht und bei der als Mischschicht ausgebildeten photoaktiven Schicht um eine unpolarisierte photoaktive Schicht.

Die photoaktive Schicht kann auch einen Matrixaufbau aufweisen.

Betrachtet man die Elektroden, so kann die erste Elektrodenschicht beispielsweise aus einer transparenten Indiumzinnoxid-Schicht (ITO) mit einer Schichtdicke von 40 bis 150 nm oder aus einem ITO-Metall-ITO-Verbund mit einer Gesamtschichtdicke von ~ 40 nm ausgebildet sein, die zweite Elektrodenschicht aus einer transparenten metallischen Schicht, vorzugsweise aus Ag oder Au mit einer Schichtdicke von 70 bis 120 nm oder aus Cr und Au mit einer Gesamtschichtdicke von 70 bis 120 nm, wobei die als Haftvermittler dienende Cr-Schicht eine Dicke von ca. 3 nm aufweisen kann. ITO bildet eine Anode, wenn auf die ITO-Schicht die Elektronenblocker-Schicht aufgebracht wird. Wenn auf die ITO-Schicht die Lochblocker-Schicht aufgebracht wird, dann bildet die ITO-Schicht eine Kathode. Die Elektronenblocker-Schicht und die Lochblocker-Schicht sind Schichten, die die Ladungstrennung in der photoaktiven Schicht unterstützen und damit den Wirkungsgrad der photovoltaischen Zelle erhöhen. Die Elektronenblocker-Schicht hindert Elektronen am Durchtritt, lässt jedoch "Löcher" durch; die Lochblocker-Schicht hindert "Löcher" am Durchtritt, lässt jedoch Elektronen durch. Auf diese Weise wird die den Wirkungsgrad mindernde Rekombination von Elektronen und "Löchern" zumindest vermindert und es werden Elektronen und "Löcher" in voneinander getrennten Ebenen konzentriert, woraus die Polarität der photovoltaischen Zelle resultiert.

Es kann aber auch vorgesehen sein, dass die Funktion der Elektronenblocker-Schicht und/oder der Lochblockerschicht von der jeweiligen Elektrodenschicht erbracht wird und so die Elektronenblocker-Schicht und/oder die Lochblocker-Schicht von der jeweiligen Elektrodenschicht gebildet wird. In diesem Fall sind beispielsweise die Austrittsarbeiten der Elektroden für die Polarität der photovoltaischen Zelle verantwortlich. Die Austrittsarbeiten der ersten und der zweiten Elektrodenschicht sollten in diesem Fall eine möglichst große Differenz haben, um in der photoaktiven Schicht ein großes inneres Potential aufzubauen, das die Trennung der gebildeten Ladungsträger (Elektronen und Löcher) erleichtert. Eine mögliche Materialkombination ist beispielsweise ITO mit einer Austrittsarbeit von 4,7 eV und Aluminium mit einer Austrittsarbeit von 4,3 eV, wobei ITO die Anode bildet und Aluminium die Kathode.

Es kann auch vorgesehen sein, dass die in einer gemeinsamen Ebene angeordneten Elektrodenschichten nicht nur wegen der inversen Schichtfolge benachbarter in der Serienschaltung verbundener photovoltaischer Zellen aus unterschiedlichem Material ausgebildet sind, beispielsweise aus einer transparenten ITO-Schicht und aus einer semitransparenten metallischen Schicht, sondern dass drei oder mehr Ausbildungen der Elektrodenschicht alternieren, beispielsweise in der Abfolge transparente ITO-Schicht, semitransparente metallische Schicht und metallische Gitterstruktur. Die metallische Gitterstruktur kann beispielsweise zugleich eine elektrische Kontaktschicht bilden.

Es kann vorgesehen sein, dass eine Elektronenblocker-Schicht zwischen der ersten Elektrodenschicht und der photoaktiven Schicht und/oder eine Lochblocker-Schicht zwischen der zweiten Elektrodenschicht und der photoaktiven Schicht angeordnet sind bzw. ist oder umgekehrt. Wenn zwischen der ersten Elektrodenschicht und der photoaktiven Schicht die Elektronenblocker-Schicht angeordnet ist, dann ist die erste Elektrodenschicht die Anode, und wenn zwischen der zweiten Elektrodenschicht und der photoaktiven Schicht die Lochblocker-Schicht angeordnet ist, dann ist die zweite Elektrodenschicht die Kathode. Die Elektronenblocker-Schicht kann beispielsweise aus PEDOT/PSS (Poly(3,4-ethylendioxythiophen) / Polystyrolsulfonat) mit einer Schichtdicke von 50 bis 150 nm gebildet sein. Die Lochblocker-Schicht kann beispielsweise aus TiOₓ mit einer Schichtdicke von 10 bis 50 nm gebildet sein. Weil die Art der Blocker-Schichten die Polarität der photovoltaischen Zelle bestimmen kann, kann auch vorgesehen sein, dass für die erste und die zweite Elektrodenschicht das gleiche Material verwendet wird. In diesem Fall kann vorteilhafterweise vorgesehen sein, auch die Verbindungsabschnitte aus dem Material der Elektrodenschichten auszubilden, woraus ein besonders einfacher Aufbau des erfindungsgemäßen photovoltaischen Moduls folgt.

Die beiden Blockerschichten können mit den Elektrodenschichten eine Einheit bilden und/oder zugleich weitere Funktionen in der photovoltaischen Zelle übernehmen, zum Beispiel als Benetzungshilfe oder/und als Barriere vorgesehen sein. Wenn die erste Elektrodenschicht beispielsweise aus ITO ist, kann zwischen der ersten Elektrodenschicht und der photoaktiven Schicht beispielsweise eine PEDOT/PSS-Schicht angeordnet sein. Die PEDOT/PSS-Schicht ist in diesem Beispiel zum einen die Elektronenblocker-Schicht und verbessert in diesem Fall die Benetzung der Elektrodenschicht mit der photoaktiven Halbleiterschicht, da die Oberflächenspannung der getrockneten PEDOT/PSS-Schicht sehr viel größer als die Oberflächenspannung der flüssig aufgebrachten Halbleiterschicht ist. Wenn die zweite Elektrodenschicht beispielsweise als eine aufgedampfte Silberschicht ausgebildet ist, dann kann eine auf die Halbleiterschicht aufgetragene PEDOT/PSS-Schicht als eine Barriere für die beim Bedampfen auftreffenden Silberatome wirken und die Wahrscheinlichkeit von Kurzschlüssen und/oder Fehlkontakten verringern.

Wegen der vorgesehenen inversen Ausbildung der Schichtfolgen der photovoltaischen Zellen kann es bevorzugt sein, beide Blocker-Schichten mit gleicher Schichtdicke auszubilden.

Es kann vorgesehen sein, dass horizontal benachbarte photovoltaische Zellen eine unterschiedliche spektrale Empfindlichkeit aufweisen.

Weiter kann vorgesehen sein, dass die photovoltaischen Zellen zwei oder mehr photoaktive Schichten mit unterschiedlicher spektraler Empfindlichkeit aufweisen. Solche Zellen werden auch als Tandem-Zellen (im Falle eines doppelten Aufbaus) oder generell als Multi-Junction-Zellen bezeichnet. Dadurch, dass die Umwandlung der Lichtenergie in elektrische Energie für mehr als einen Spektralbereich vorgesehen ist, ist der Wirkungsgrad der Multi-Junction-Zelle gegenüber einer photovoltaischen Zelle mit nur einer photoaktiven Schicht erhöht. Photovoltaische Zellen mit nur einer photoaktiven Schicht werden auch als Single-Junction-Zellen bezeichnet. Zum Aufbau von Multi-Junction-Zellen können mehrere Schichtfolgen aus Lochblocker-Schicht, photovoltaischen Halbleiterschicht und Elektronenblocker-Schicht vorgesehen sein, die zwischen den Elektrodenschichten angeordnet sind.

Die mit unterschiedlicher spektraler Empfindlichkeit ausgebildeten photoaktiven Schichten können weiter einen unterschiedlichen Aufbau aufweisen, wie weiter oben für Single-Junction-Zellen beschrieben.

Vorteilhafterweise kann vorgesehen sein, zwischen aufeinander folgende Elektronenblocker-Schicht und Lochblocker-Schicht oder umgekehrt zum Beispiel eine aus metallischen Clustern gebildete Schicht einzubringen. Unter Clustern wird in der Physik eine Ansammlung von Atomen oder Molekülen verstanden, deren Atomanzahl zwischen n = 3 und n = 50.000 liegt.

Es ist weiter möglich, dass horizontal benachbarte photovoltaische Zellen eine unterschiedliche Breite und/oder Kontur aufweisen. Auf diese Weise ist bei gleichem Zellenaufbau eine weitere Gestaltungsmöglichkeit gegeben. Eine unterschiedliche Breite der photovoltaischen Zellen kann beispielsweise vorgesehen sein, um Zellen mit verschiedenen photovoltaischen Schichten in ihren elektrischen Werten, wie z.B. den Innenwiderstand, anzugleichen.

Es kann weiter vorgesehen sein, dass die Trägerschicht flexibel ausgebildet ist. Die Trägerschicht kann beispielsweise als eine Trägerfolie mit einer Dicke von 12 µm bis 150 µm ausgebildet sein. Als Material kommen insbesondere PET, PEN oder PVC in Betracht. Auch Kombinationen daraus sind möglich.

Es kann auch vorgesehen sein, dass die Trägerschicht starr ausgebildet ist, beispielsweise aus Glas. Eine starre Trägerschicht kann vorteilhaft sein, um beispielsweise Verglasungen für Fenster oder transparente Wandflächen auszubilden, die gleichzeitig als Energiequelle nutzbar sind.

In einer weiteren vorteilhaften Ausbildung ist vorgesehen, dass die Trägerschicht uneben und/oder mit unebener Oberfläche ausgebildet ist. Auf diese Weise verfügt die Trägerschicht über eine größere Oberfläche auf als eine ebene bzw. nicht verformte Trägerschicht, so dass zur Energiegewinnung eine größere effektive Fläche zur Verfügung steht.

Weiter kann vorgesehen sein, dass die Trägerschicht eine Färbung aufweist. Die Färbung kann beispielsweise dekorative Zwecke erfüllen, etwa zur künstlerischen Gestaltung von Fensterflächen verwendet werden, oder zur Lichtfilterung vorgesehen sein. So kann beispielsweise ein Sonnenschutz mit einem erfindungsgemäßen photovoltaischen Modul beschichtet sein, das wie weiter oben beschrieben, als biegsamer Folienkörper ausgebildet ist.

Es kann auch vorgesehen sein, dass die Trägerschicht die Lichtführung beeinflussende Elemente aufweist. Die Trägerschicht kann beispielsweise lichtstreuende oder lichtleitende Partikel aufweisen. Sie kann aber auch geometrische Elemente aufweisen, d.h. beispielsweise so geformt sein, dass sie Licht zu bündeln vermag.

Weitere Ausbildungen sind auf die Gestaltung der Elektrodenschichten gerichtet.

Es kann vorgesehen sein, dass mindestens eine der Elektrodenschichten der photovoltaischen Zelle eine metallische Schicht ist, insbesondere aus einem Metall oder einer Legierung aus mehreren Metallen. Es kann sich dabei um eine homogene Schicht handeln oder auch um eine leitfähige Schicht mit Nanopartikeln, sogenannten Clustern.

Es kann aber auch vorgesehen sein, dass mindestens eine der Elektrodenschichten der photovoltaischen Zelle eine elektrisch leitende organische Schicht ist. Organische Schichten können besonders einfach durch einen Druckprozess aufgebracht werden, so dass organische Schichten gegenüber metallischen Schichten bevorzugt sein können. Dotiertes Polyethylen, Polyanilin und organische Halbleiter haben sich beispielsweise als Elektrodenschichten bewährt.

Zwecks transparenter Ausbildung, d.h. ausreichend strahlungsdurchlässiger Ausbildung, kann vorgesehen sein, der Strahlungsquelle zugewandte Elektrodenschichten als transparente, semitransparente (Metallschichten mit sehr geringer Schichtdicke), als Gitterstruktur oder als Kombination dieser Ausführungen auszubilden. Die Gitterstruktur kann vorzugsweise so dimensioniert sein, dass sie mit bloßem Auge nicht sichtbar ist.

Wegen der inversen Anordnung benachbarter photovoltaischer Zellen des erfindungsgemäßen photovoltaischen Moduls ist es bevorzugt, dass beide Elektrodenschichten transparent und/oder mit einer Gitterstruktur ausgebildet sind.

Weitere Ausbildungen sind auf die Konfektionierung des photovoltaischen Moduls gerichtet.

Es kann vorgesehen sein, dass das Modul als eine Präge-Folie oder eine Laminier-Folie oder eine Touchform-Folie oder eine Inmold-Folie ausgebildet ist.

Das erfindungsgemäße photovoltaische Modul kann also auch als Halbzeug eingesetzt werden, um Endprodukte herzustellen, die neben dem Haupteinsatzzweck zur umweltfreundlichen Solar-Energiegewinnung einsetzbar sind. Es können beispielsweise Fahrzeugkarosserien, Wetter-Ballons und Verkehrsleiteinrichtungen mit Hilfe der genannten Folien ausgebildet und/oder beschichtet werden.

Weitere vorteilhafte Ausbildungen sind auf das Herstellungsverfahren gerichtet.

Vorteilhafterweise kann vorgesehen sein, dass die organische photoaktive Schicht durch einen Druckprozess partiell aufgebracht wird. Die Schichtdicke kann vorteilhafterweise im Bereich von 50 nm bis 250 nm gewählt sein. Unter dem partiellen Aufbringen ist hier und im folgenden verstanden, dass die photoaktive Schicht nicht ganzflächig aufgetragen ist, sondern eine partiell ausgebildete Schicht bildet, die Bereiche aufweist, in denen kein photoaktives Material aufgetragen ist.

Es kann auch vorgesehen sein, dass die photoaktive Schicht zunächst vollflächig aufgetragen wird und sodann strukturiert wird, beispielsweise durch Ätzen oder durch Laserablation. Die Bereiche ohne photoaktives Material grenzen die photovoltaischen Zellen des photovoltaischen Moduls voneinander ab und können beispielsweise partiell oder vollständig durch ein isolierendes Material aufgefüllt sein.

Weiter kann vorgesehen sein, dass die Lochblocker-Schicht und/oder die Elektronenblocker-Schicht durch einen Druckprozess partiell aufgebracht werden bzw. wird. Es kann aber auch vorgesehen sein, dass die Blocker-Schichten zunächst vollflächig aufgebracht werden und sodann strukturiert bzw. partiell abgetragen werden, wie weiter oben beschrieben.

Es kann also vorgesehen sein, dass mindestens eine der Schichten des photovoltaischen Moduls vollflächig aufgebracht wird und sodann durch partielles Abtragen der Schicht strukturiert wird.

Es kann weiter vorgesehen sein, dass die erste Elektrodenschicht und/oder die zweite Elektrodenschicht und/oder der Verbindungsabschnitt durch einen Druckprozess partiell aufgebracht werden bzw. wird. Falls die erste und die zweite Elektrodenschicht sowie die Verbindungsabschnitte aus dem gleichen Material mit der gleichen Schichtdicke ausgebildet sind, kann auch vorgesehen sein, dass die genannten Schichten zunächst als vollflächige Schicht aufgebracht werden und sodann strukturiert bzw. partiell abgetragen werden, wie weiter oben beschrieben.

Vorzugsweise kann vorgesehen sein, dass der Schichtaufbau des photovoltaischen Moduls vollständig gedruckt wird, wie weiter oben beschrieben.

Es kann aber auch vorgesehen sein, dass die erste Elektrodenschicht und/oder die zweite Elektrodenschicht und/oder der Verbindungsabschnitt aufgedampft oder aufgesputtert werden bzw. wird. Es kann sich dabei vorzugsweise um metallische Elektroden oder anorganische Elektroden handeln, die durch Sputtern oder Aufdampfen in höherer Qualität zu fertigen sind, als durch Aufdrucken einer mit Elektrodenpartikeln versetzten Druckpaste.

Weiter ist möglich, dass mindestens eine der Schichten des photovoltaischen Moduls durch einen Laminier-Prozesse aufgebracht wird. Es können beispielsweise unterschiedliche Laminierfolien vorgesehen sein, die in unterschiedlicher Weise kombinierbar sind und so insbesondere für Kleinserien eine sehr kostengünstige Lösung bei hoher Qualität des Endprodukts ermöglichen.

Weiter kann vorgesehen sein, dass das photovoltaische Modul einlaminiert wird. Insbesondere photovoltaische Module auf Folienbasis können sehr einfach einlaminiert werden und so zuverlässig gegen die Lebensdauer begrenzende Umwelteinflüsse, wie Feuchtigkeit und Luftsauerstoff, geschützt werden.

Die Erfindung wird nun anhand der Zeichnungen näher erläutert. Es zeigen:
- Fig. 1: eine schematische Schnittansicht eines photovoltaischen Moduls nach dem Stand der Technik;
- Fig. 2: eine schematische Schnittdarstellung eines ersten Ausführungsbeispiels des erfindungsgemäßen photovoltaischen Moduls;
- Fig. 3: eine schematische Schnittdarstellung eines zweiten Ausführungsbeispiels des erfindungsgemäßen photovoltaischen Moduls.

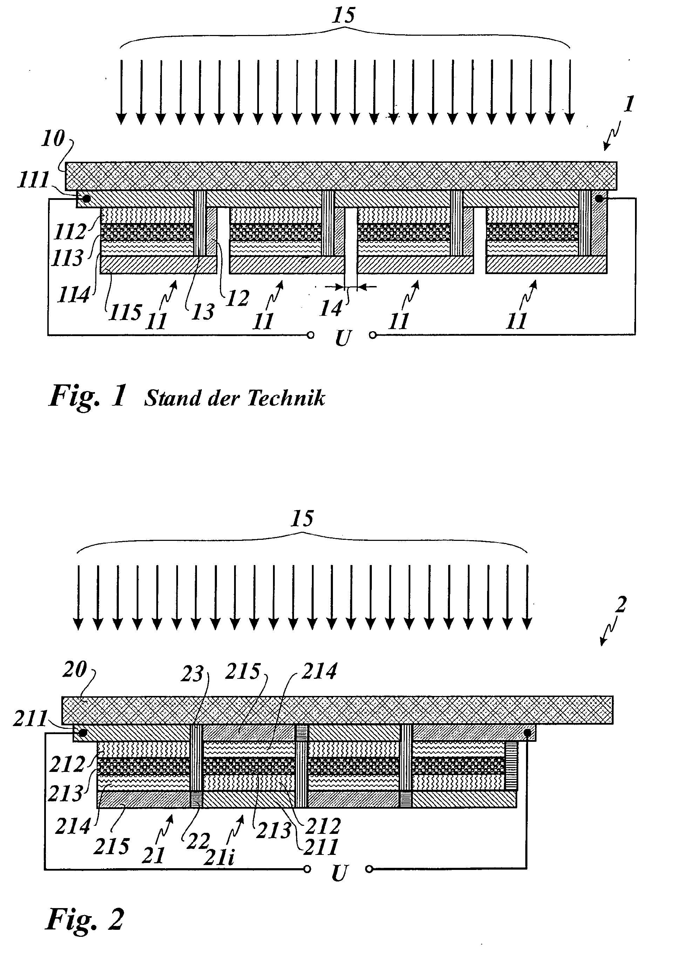

Fig. 1 zeigt ein photovoltaisches Modul 1 nach dem Stand der Technik, das als Mehrschichtkörper ausgebildet ist und das an von außen zugänglichen Kontaktflächen eine Klemmenspannung U bereitstellt, wenn es Licht, beispielsweise Sonnenlicht, ausgesetzt ist.

Auf einer Trägerschicht 10 sind photovoltaische Zellen 11 von Art der sogenannten Single Junction Zellen angeordnet, die in einer Serienschaltung miteinander verbunden sind. Bei der Trägerschicht kann es sich beispielsweise um eine PET-Folie handeln mit einer Dicke von etwa 20 bis 25 µm.

Die photovoltaischen Zellen 11 bestehen aus übereinander angeordneten Schichten und zwar aus einer ersten Elektrodenschicht 111, die unmittelbar auf der Trägerschicht 10 aufgebracht ist und einfallenden Lichtstrahlen 15 zugewandt ist, einer Elektronenblocker-Schicht 112, einer organischen photoaktiven Schicht 113, einer Lochblocker-Schicht 114 und einer zweiten Elektrodenschicht 115. Zwei in der Serienschaltung aufeinanderfolgende photovoltaische Zellen 11 sind durch auf der Trägerschicht 10 senkrecht angeordnete elektrisch leitfähige Verbindungsabschnitte 12 elektrisch leitend miteinander verbunden, wobei jeweils die zweite Elektrodenschicht 115 der vorangehenden photovoltaischen Zelle 11 mit der ersten Elektrodenschicht 111 der nachfolgenden photovoltaischen Zelle 11 verbunden ist. Der Verbindungsabschnitt 12 ist durch einen Trennabschnitt 13 von der photovoltaischen Zelle 11 elektrisch isoliert. Der Trennabschnitt 13 ist an einer Schmalseite der photovoltaischen Zelle 11 angeordnet. Es kann sich dabei beispielsweise um eine elektrisch isolierende Kleberschicht oder um einen aushärtbaren Isolator, beispielsweise ein Zweikomponentensystem aus Epoxidharz und Härter handeln. Der Verbindungsabschnitt 12 ist von der nachfolgenden photovoltaischen Zelle durch einen Luftspalt 14 getrennt. Anstelle des Luftspalts 14 könnte auch eine den Spaltraum ausfüllende Isolierschicht vorgesehen sein. Bei den photoaktiven Schichten handelt es sich Schichten vom Polymer-Typ, wie weiter unten in Fig. 2 näher beschrieben.

In den Bereichen des Verbindungsabschnitts 12, des Trennabschnitts 13 und des Luftspalts 14 tragen die auf das photovoltaische Modul 1 auftreffenden Lichtstrahlen 15 nicht zur Energiegewinnung bei und verringern deshalb die Effektivität des photovoltaischen Moduls 1.

Fig. 2 zeigt nun in einem ersten Ausführungsbeispiel ein erfindungsgemäßes photovoltaisches Modul 2 mit einer Trägerschicht 20, das sich von dem in Fig. 1 dargestellten photovoltaischen Modul 1 nach dem Stand der Technik dadurch unterscheidet, dass aufeinander folgende photovoltaische Zellen mit inverser Schichtfolge ausgebildet sind.

Eine in der Serienschaltung vorangehende photovoltaische Zelle 21 weist ausgehend von der Trägerschicht 20 eine erste Elektrodenschicht 211, eine Elektronenblocker-Schicht 212, einer organische photoaktive Schicht 213, eine Lochblocker-Schicht 214 und eine zweite Elektrodenschicht 215 auf. Eine in der Serienschaltung auf die photovoltaische Zelle 21 folgende photovoltaische Zelle 21 i weist eine inverse Schichtfolge auf, d.h. nunmehr ist die zweite Elektrodenschicht 215 auf der Trägerschicht 20 angeordnet und die erste Elektrodenschicht 211 ist die oberste, von der Trägerfolie 20 abgewandte Schicht der photovoltaischen Zelle 21 i. Auch die Blocker-Schichten haben folglich in der inversen Zelle ihre Plätze getauscht.

Die erste Elektrodenschicht 211 kann als eine transparente Indiumzinnoxid-Schicht (ITO) mit einer Schichtdicke von 10 bis 15 nm ausgebildet sein, die zweite Elektrodenschicht 215 aus einer semitransparenten metallischen Schicht, vorzugsweise aus Silber, Gold oder Chrom/Gold , mit einer Schichtdicke von 10 bis 30 nm ausgebildet sein. Die zweite Elektrodenschicht kann aber auch in Form eines Gitters obiger Metalle oder Metallkombinationen aufgebaut sein, wobei nun die metallischen Bereiche Dicken bevorzugt bis zu 120 nm aufweisen können. Die photoaktive Schicht 213 kann beispielsweise aus einem Gemisch aus als Donator wirkendem konjugiertem Polymer, wie P3HT (regioreguläres poly(3-hexyl thiophene) oder MDMO-PPV [poly(2-methoxy-5-(3-,7-dimethyloctyloxy)-1,4-phenylenvinylen], und als Akzeptor wirkenden Fullerenen, wie C₆₀, oder PCBM ([6,6]-phenyl-C₆₁-butric acid methyl ester) aufgebaut sein.

In dem in Fig. 2 dargestellten Ausführungsbeispiel ist bei der bevorzugten Materialpaarung die erste Elektrodenschicht 211 die Anode, d.h. der Pluspol, und die zweite Elektrodenschicht 215 die Kathode, d.h. der Minuspol der photovoltaischen Zellen 21, 21i.
Es kann auch vorgesehen sein, dass eine oder beide der Blocker-Schichten 212, 213 entfallen. Beispielsweise kann nur zwischen der aus ITO ausgebildeten ersten Elektrodenschicht 211 und der photoaktiven Schicht 213 eine PEDOT/PSS-Schicht als Elektronenblocker-Schicht vorgesehen sein. Bei einer solchen Anordnung ist zu beachten, dass die photoaktiven Schichten 213 benachbarter Zellen 21, 21 i nicht in einer gemeinsamen Ebene angeordnet sind. Wenn die photoaktiven Schichten 213 weiter als Schichtsystem aus zwei übereinander angeordneten Teilschichten vom p-Halbleitertyp bzw. vom n-Halbleitertyp ausgebildet sind, ist zu beachten, dass auch diese Schichtfolge invertiert werden muss.

In dem in Fig. 2 dargestellten Ausführungsbeispiel sind die beiden Elektrodenschichten 211, 215 mit gleicher Schichtdicke ausgebildet, so dass die Elektrodenschichten der benachbarten photovoltaischen Zellen 21, 21 i in einer Ebene liegen. Sie können deshalb unmittelbar durch einen elektrisch leitfähigen Verbindungsabschnitt 22, der vorzugsweise die gleiche Dicke wie die beiden Elektrodenschichten 211, 215 aufweist, elektrisch leitend miteinander verbunden werden. Zur elektrischen Trennung zwischen den beiden benachbarten photovoltaischen Zellen 21, 21 i ist ein auf der Trägerschicht 20 senkrecht angeordneter Trennabschnitt 23 vorgesehen. Der Trennabschnitt 22 kann beispielsweise als Kleberschicht oder aus einem aushärtbaren System, beispielsweise einem Zweikomponentensystem, ausgebildet sein.

Die photovoltaische Zelle 21 i weist den gleichen Schichtaufbau wie die photovoltaische Zelle 21 auf, jedoch in inverser Schichtfolge.

Unter der Annahme, dass die drei in der Fig. 1 genannten, den Lichteinfall maskierenden Elemente Verbindungsabschnitt 12, Trennabschnitt 13 und Luftspalt 14 die gleiche Dicke aufweisen wie der in Fig. 2 dargestellte Trennabschnitt 23, so ist in dem erfindungsgemäßen photovoltaischen Modul 2 (Fig. 2) der Abschattungsbereich gegenüber dem photovoltaischen Modul 1 (Fig. 1) nach dem Stand der Technik auf 1/3 reduziert. Durch diese Vorgehensweise wird der geometrische Füllfaktor des Moduls - auch mit GFF bezeichnet - erhöht.

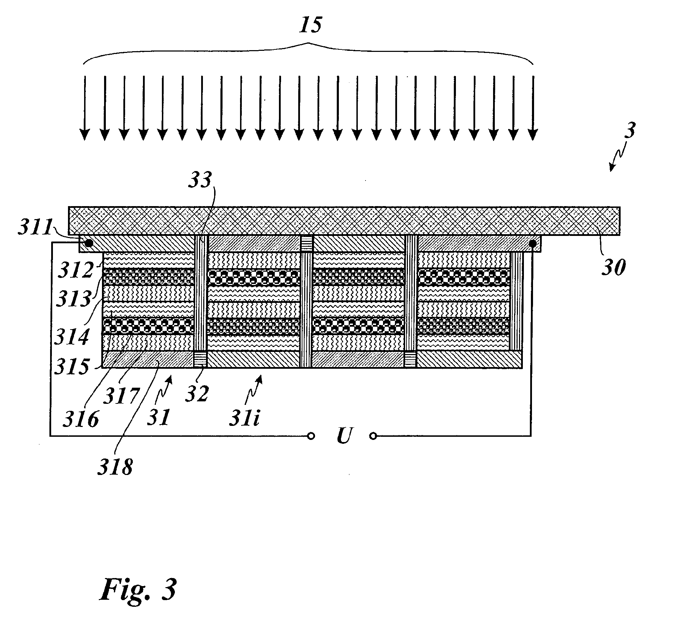

Fig. 3 zeigt ein photovoltaisches Modul 3 mit sogenannten Tandem-Zellen. Eine Tandem-Zelle besteht aus zwei photovoltaischen Zellen mit verschiedenem photoaktivem Material, die übereinander geschichtet sind. Auf eine erste Elektrodenschicht 311 folgt eine erste Elektronenblocker-Schicht 312, eine erste photoaktive Schicht 313, eine erste Lochblocker-Schicht 314, eine zweite Elektronenblocker-Schicht 315, eine zweite photoaktive Schicht 316, eine zweite Lochblocker-Schicht 317 sowie eine zweite Elektrodenschicht 318. Zwischen der ersten Lochblocker-Schicht 314 und der zweiten Elektronenblocker-Schicht 315 kann eine oder können mehrere in Fig. 4 nicht dargestellte Schicht bzw. Schichten angeordnet sein.

Das photovoltaische Modul 3 nutzt also die Energie des einfallenden Lichtes in einem großen Spektralbereich aus und verfügt deshalb über einen höheren Wirkungsgrad als das weiter oben in Fig. 2 beschriebene photovoltaische Modul 2 mit nur einer photoaktiven Schicht.

Die in den vorgenannten Ausführungsbeispielen vorgesehenen Elektrodenschichten sind vorzugsweise transparent oder semitransparent ausgebildet, wobei die jeweils der Lichteintrittsseite abgewandte Elektrodenschicht auch semitransparent oder nicht transparent ausgebildet sein kann.

Die erste und die zweite Elektrodenschicht 211 und 215 bzw. 311 und 318 (Fig. 2 und Fig. 3) können auch aus dem gleichen Material ausgebildet sein, beispielsweise aus Silber, Gold oder Chrom/Gold. Vorteilhafterweise können auch die Verbindungsabschnitte 22 bzw. 32 aus dem einheitlichen Elektrodenmaterial ausgebildet sein, so dass benachbarte Elektrodenschichten zusammen mit den sie elektrisch verbindenden Verbindungsabschnitten einen gemeinsamen Bereich bilden können, woraus ein besonders einfacher Aufbau der Module 2 bzw. 3 folgt.

Weil die einzelnen Schichten der erfindungsgemäßen photovoltaischen ModuleDicken im Nanometer-Bereich, maximal im Mikrometer-Bereich aufweisen, können diese Module nahezu beliebig verformt werden, so dass sie beispielsweise auch zu Schläuchen geformt werden können oder auf Schläuche aufgebracht werden können. Schlauchförmige photovoltaische Module können durch ein durch die Schläuche fließendes Medium, beispielsweise Wasser, die als Wärmeenergie vorliegende Restenergie des Lichtes nutzen, indem das Medium einer Wärmepumpe oder einem Wärmetauscher zugeführt wird.

Halbleitersolarzellen werden zur Energiegewinnung meist zu großen Solarmodulen verschaltet. Die Zellen werden dafür mit Leiterbahnen an Vorder- und Rückseite in Reihe geschaltet. Dadurch addiert sich die Spannung der Einzelzellen und es können dünnere Drähte für die Verschaltung verwendet werden als bei einer Parallelschaltung. Als Schutz vor einem Lawinendurchbruch in den einzelnen Zellen (z.B. bei Teilabschattung) müssen jedoch zusätzlich Schutz-Dioden (Bypass-Dioden) parallel zu den Zellen eingebaut, die von Abschattung betroffene Zellen überbrücken können.

## Patentansprüche

1. Als Mehrschichtkörper ausgebildetes photovoltaisches Modul mit zwei oder mehr auf einer Trägerschicht angeordneten photovoltaischen Zellen, die in einer Serienschaltung elektrisch miteinander verbunden sind, wobei die photovoltaischen Zellen eine erste und eine zweite Elektrodenschicht und mindestens eine organische photoaktive Schicht auf Polymerbasis aufweisen, die zwischen einer Lochblocker-Schicht und einer Elektronenblocker-Schicht angeordnet ist,
**dadurch gekennzeichnet,**
**dass** die Lochblocker-Schichten (214, 414, 417) und die Elektronenblocker-Schichten (212, 412, 415) in der Serienschaltung aufeinander folgender benachbarter photovoltaischer Zellen (21, 21 i, 41, 41 i) in Bezug auf die Trägerschicht (20, 40) zueinander in inverser Abfolge angeordnet sind, und dass durch einen elektrisch leitenden Verbindungsabschnitt (22, 42) elektrisch miteinander verbundene Elektrodenschichten (211, 215, 411, 418) der aufeinander folgenden benachbarten photovoltaischen Zellen (21, 21 i, 41, 41 i) in einer gemeinsamen Ebene angeordnet sind.

2. Photovoltaisches Modul nach Anspruch 1,
**dadurch gekennzeichnet,**
**dass** die Schichtdicken der Schichten der photovoltaischen Zellen (21, 21i, 41, 41 i) so gewählt sind, dass benachbarte Schichten aufeinander folgender photovoltaischer Zellen (21, 21 i, 41, 41 i) jeweils mit gleicher Dicke ausgebildet sind.

3. Photovoltaisches Modul nach Anspruch 2,
**dadurch gekennzeichnet,**
**dass** die Schichten der photovoltaischen Zellen (21, 21 41, 41 i) mit gleicher Schichtdicke ausgebildet sind.

4. Photovoltaisches Modul nach einem der vorangehenden Ansprüche,
**dadurch gekennzeichnet,**
**dass** in der Serienschaltung aufeinander folgende photovoltaische Zellen (21, 21 i, 41, 41 i) mit inverser Schichtfolge ausgebildet sind.

5. Photovoltaisches Modul nach einem der vorangehenden Ansprüche,
**dadurch gekennzeichnet,**
**dass** horizontal benachbarte photovoltaische Zellen (21, 21i, 41, 41 i) photoaktive Schichten mit unterschiedlicher spektraler Empfindlichkeit aufweisen.

6. Photovoltaisches Modul nach einem der vorangehenden Ansprüche,
**dadurch gekennzeichnet,**
**dass** die photovoltaischen Zellen (41, 41i) jeweils zwei oder mehr photoaktive Schichten (413, 416) mit unterschiedlicher spektraler Empfindlichkeit aufweisen.

7. Photovoltaisches Modul nach einem der vorangehenden Ansprüche,
**dadurch gekennzeichnet,**
**dass** horizontal benachbarte photovoltaische Zellen (21, 21 i, 41, 41 i) eine unterschiedliche Breite und/oder Kontur aufweisen.

8. Photovoltaisches Modul nach einem der vorangehenden Ansprüche,
**dadurch gekennzeichnet,**
**dass** die Trägerschicht (20, 30, 40) die Lichtführung beeinflussende Elemente aufweist.

9. Photovoltaisches Modul nach einem der vorangehenden Ansprüche,
**dadurch gekennzeichnet,**
**dass** mindestens eine der Elektrodenschichten (211, 215, 411, 418) der photovoltaischen Zellen (21, 21 i, 41, 41 i) eine metallische Schicht ist, insbesondere aus einem Metall oder einer Legierung aus mehreren Metallen.

10. Photovoltaisches Modul nach einem der vorangehenden Ansprüche,
**dadurch gekennzeichnet,**
**dass** das Modul (2, 2', 3, 4) als eine Präge-Folie ausgebildet ist.

11. Photovoltaisches Modul nach einem der Ansprüche 1 bis 9,
**dadurch gekennzeichnet,**
**dass** das Modul (2, 2', 3, 4) als eine Laminier-Folie ausgebildet ist.

12. Photovoltaisches Modul nach einem der Ansprüche 1 bis 9,
**dadurch gekennzeichnet,**
**dass** das Modul (2, 2', 3, 4) als eine Touchform-Folie ausgebildet ist.

13. Photovoltaisches Modul nach einem der Ansprüche 1 bis 9,
**dadurch gekennzeichnet,**
**dass** das Modul (2, 2', 3, 4) als eine Inmold-Folie ausgebildet ist.

14. Verfahren zur Herstellung eines als Mehrschichtkörper ausgebildeten photovoltaischen Moduls mit zwei oder mehr in Serie geschalteter photovoltaischer Zellen, wobei die photovoltaischen Zellen eine erste und eine zweite Elektrodenschicht und mindestens eine organische photoaktive Schicht auf Polymerbasis aufweisen, die zwischen einer Lochblocker-Schicht und einer Elektronenblocker-Schicht angeordnet ist, aufweisen,
**dadurch gekennzeichnet,**
**dass** bei dem Verfahren auf eine Trägerschicht (20, 40) die weiteren Schichten so aufgebracht werden, dass die Lochblocker-Schichten (214, 414, 417) und die Elektronenblocker-Schichten (212, 412, 415) in der Serienschaltung aufeinander folgender benachbarter photovoltaischer Zellen (21, 21i, 41, 41 i) in Bezug auf die Trägerschicht (20, 40) zueinander in inverser Abfolge angeordnet sind, und dass die durch einen elektrisch leitenden Verbindungsabschnitt (22, 42) elektrisch miteinander verbundenen Elektrodenschichten (211, 215, 411, 418) der aufeinander folgenden benachbarten photovoltaischen Zellen (21, 21 i, 41, 41 i) in einer gemeinsamen Ebene angeordnet sind.

15. Verfahren zur Herstellung eines photovoltaischen Moduls nach Anspruch 14,
**dadurch gekennzeichnet,**
**dass** die organische photoaktive Schicht (213, 413, 416) durch einen Druckprozess partiell aufgebracht wird.

16. Verfahren zur Herstellung eines photovoltaischen Moduls nach Anspruch 14 oder 15,
**dadurch gekennzeichnet,**
**dass** die Lochblocker-Schicht (214, 414, 417) und/oder die Elektronenblocker-Schicht (212, 412, 415) durch einen Druckprozess partiell aufgebracht werden bzw. wird.

17. Verfahren zur Herstellung eines photovoltaischen Moduls nach einem der Ansprüche 14 bis 16,
**dadurch gekennzeichnet,**
**dass** mindestens eine der Schichten des photovoltaischen Moduls (2, 2', 3, 4) durch einen Laminier-Prozesse aufgebracht wird.

18. Verfahren zur Herstellung eines photovoltaischen Moduls nach einem der Ansprüche 14 bis 17,
**dadurch gekennzeichnet,**
**dass** mindestens eine der Schichten des photovoltaischen Moduls (2, 2', 3, 4) vollflächig aufgebracht wird und sodann durch partielles Abtragen der Schicht strukturiert wird.
